# EUROPÄISCHE PATENTANMELDUNG

(11) **EP 2 653 896 A1**
(43) Veröffentlichungstag der Anmeldung: **23.10.2013**
(21) Anmeldenummer: 12164655.8
(22) Anmeldetag: 18.04.2012
(51) Int. Cl.: G02B 1/10, G02B 5/08, C23C 28/00, C23C 14/00

(54) **Verfahren zur Herstellung eines thermisch belastbaren Reflektors**

(71) Anmelder: Novatec Solar GmbH, 76133 Karlsruhe (DE)
(72) Erfinder: Die Erfindernennung liegt noch nicht vor
(74) Vertreter: Geitz Truckenmüller Lucht

(57) **Zusammenfassung**

Es ist aus dem Stand der Technik bereits bekannt, für solarthermische Anwendungen Reflektoren zu verwenden, die eine Reflexionsschicht aus Silber aufweisen. Derartige Reflektoren sollen sowohl einen besonders hohen Reflexions- und thermischen Emissionsgrad aufweisen, was zu einer großen Effektivität der betreffenden Solarthermieanlage führt. Aufgrund der sehr hohen thermischen Belastung insbesondere der Sekundärreflektoren solcher Anlagen, sind bei bekannten Lösungen über lange Betriebszeiten Reflexionsverluste aufgrund von Diffusion aus umgebenden Schichten oder Oxidation und Agglomeration des Silbers zu beklagen.

Die Erfindung schlägt vor diesem Hintergrund ein Herstellungsverfahren für einen Reflektor vor, bei dem auf die Reflexionsschicht zunächst eine dünne Schicht aus Aluminium aufgetragen und dieses anschließend thermisch oder in einem Plasma einer Gasentladung oxidiert wird. Der geforderte hohe thermische Emissionsgrad des Reflektors wird durch eine ausreichend dicke, mittels einer Sol-Gel-Beschichtung aufgebrachte silikatische Schicht gesichert.

## Beschreibung

Die vorliegende Erfindung betrifft ein Verfahren zur Herstellung eines thermisch belastbaren Reflektors, insbesondere für solarthermische Anwendungen, wobei eine Reflexionsschicht aus Silber unter Zwischenlage einer haftvermittelnden substratseitigen Diffusionsbarriere auf ein Substrat aufgebracht wird und die Reflexionsschicht ihrerseits mit einer reflexionsseitigen Diffusionsbarriere aus Aluminiumoxid überzogen wird.

Ein derartiges Herstellungsverfahren ist bereits aus der internationalen Offenlegungsschrift WO 2007/059883 A1 bekannt. Insbesondere werden in dieser Schrift eine Reihe von Möglichkeiten offenbart, einen beschichteten Spiegel mit einer metallischen Reflexionsschicht herzustellen, wobei dieser letztlich mit einer Schutzschicht gegen mechanische Beschädigung und Korrosion aus Sol-Gel-Lack überzogen wird.

Unter anderem ist aus dieser Offenlegungsschrift bekannt, auf ein Substrat, beispielsweise auf ein bandförmiges Substrat aus Aluminium, welches idealerweise durch Schleifen, Strahlen, Bürsten oder Polieren vorbehandelt und geglättet worden ist, zunächst eine haftvermittelnde Diffusionsbarriere aufzubringen, indem die Oberfläche des Aluminiumsubstrats oxidiert wird. Hierauf wird sodann die üblicherweise metallische Reflexionsschicht aufgetragen, welche je nach Bedarf aus Aluminium, Silber, Kupfer, Gold, Chrom, Nickel oder einer Legierung bestehen kann. Weitere Schutzschichten aus verschiedenen Oxiden werden dann oberhalb der Reflexionsschicht angebracht, wobei abschließend eine Sol-Gel-Schicht hinzugefügt wird.

Eher nebenbei offenbart insoweit dieser Stand der Technik die Verwendung einer Reflexionsschicht aus Silber, wobei eine Reflexionsschicht aus Silber einen sehr hohen Reflexionsgrad aufweist. In Anwendungen wie der Solarthermie ist das Vorhandensein eines besonders hohen Reflexionsgrades von eminenter Wichtigkeit, da von der Reflexionsfähigkeit des verwendeten Spiegelmaterials die Wärmeausbeute direkt abhängt.

Silber ist jedoch nicht nur ein rein bevorzugtes Material, vielmehr bringt es einige Probleme bei der Herstellung derartiger Spiegel mit sich. Nicht nur muss festgestellt werden, dass Silber unter Einwirkung von Sauerstoff und Schwefelverbindungen nicht nur korrodiert und seine hohe Reflektivität verliert, sondern in dünnen Schichten bei Sauerstoffanwesenheit und Temperaturen oberhalb von 200°C agglomeriert. Hierdurch entstehen Löcher in der Silberschicht, wodurch die eigentliche Reflexionsschicht teiltransparent wird und der Reflexionsgrad nochmals deutlich abnimmt. Auch die Forderung nach einem hohen thermischen Emissionsgrad erfüllt Silber mit seinen zwei bis drei Prozent nicht. Zudem ist es weich und kratzempfindlich.

Bei solarthermischen Anwendungen wird ein derartiger Spiegel jedoch teilweise unter sehr hoher thermischer Beanspruchung, insbesondere oberhalb von 200°C, betrieben, etwa bei einem Einsatz als Sekundärreflektor, welcher ein mit der gesammelten Sonnenenergie beaufschlagtes und hoch erhitztes Absorberrohr umgibt, das den Reflektor aufheizt. Bei einer derart hohen Wärmebelastung des Reflektors und der bestehenden hohen Anforderung an den Reflexionsgrad, sollen derartige Sekundärreflektoren in Solarthermieanlagen auch über längere Zeiträume hinweg betrieben werden können, beispielsweise über 20 Jahre hinweg, so dass der hohe Reflexionsgrad idealerweise über eine lange Zeit hinweg unverändert bleiben sollte.

Bei der Herstellung von thermisch langzeitstabilen Silberspiegeln, welche grundsätzlich im Stand der Technik bereits bekannt ist, bestehen für verschiedene auftretende Effekte bereits technische Lösungen. So sind Silberspiegel bekannt, die gegen mechanische Beschädigung und chemische Degradation geschützt werden. Hierzu gehören beispielsweise Spiegel für Primärreflektoren in Solarthermieanlagen oder astronomische Spiegel. Aufgebrachte transparente λ/4-Oxidschichten dienen bei diesen Spiegeln der Reflexionserhöhung und sind nicht ausdrücklich auf andere Effekte ausgelegt.

Ein derartiger anderer Effekt besteht darin, dass eine Verschlechterung der Reflexionsschicht durch eine Sauerstoffdiffusion, beispielsweise aus dem Substrat oder der Umgebungsluft, festgestellt werden kann. Für die Langzeitstabilität des Reflexionsgrades der Silberschicht unter den genannten Umgebungsbedingungen ist daher die Wirksamkeit der Sauerstoffbarrieren beiderseits der Reflexionsschicht entscheidend. Als Sauerstoffbarrieren eingesetzte oxidische Schichten müssen, damit sie hochwirksam werden, idealerweise weitgehend stöchiometrisch, dicht und defektfrei sein. Üblicherweise werden sie in einem vakuumtechnischen Prozess durch reaktives und plasmagestütztes thermisches Verdampfen, reaktives Sputtern und plasmaunterstützte chemische Dampfphasenabscheidung aufgebracht. Bei der Beschichtung des Silbers führt die dabei erforderliche Anwesenheit eines oxidierenden Gases, vorzugsweise von Sauerstoff, das durch das Plasma aktiviert ist, dazu, dass es bereits zu Beginn der Beschichtung in einem Maße oxidiert wird, dass ein deutlicher und nicht tolerierbarer Reflexionsverlust eintritt. Eine nicht derartig aktivierte Beschichtung führt jedoch wiederum zu weniger dichten und defektreicheren Schichten mit verminderter Barrierewirkung.

Bekanntermaßen kann die Barrierewirkung erhöht werden, wenn man zwei oder mehr Schichten unterschiedlicher oxidischer Werkstoffe aufbringt, wobei die spektrale Transparenz an das Reflexionsspektrum des Silbers angepasst sein muss. Die naheliegende Verwendung von oxidischen, vorzugsweise silikatischen, bei 120°C bis 200°C vernetzten Sol-Gel-Schichten sind wegen ihrer Sauerstoffpermeabilität als Sauerstoffbarriereschichten nicht geeignet, können aber in ausreichender Dicke die thermische Emissivität, die dünnen oxidischen Barriereschichten fehlt, liefern.

Letzten Endes muss festgestellt werden, dass der Stand der Technik kein Herstellungsverfahren für einen Reflektor mit einer Reflexionsschicht aus Silber kennt, welches Maßnahmen trifft, um den hohen Reflexionsgrad der Silberschicht sowohl während des Herstellungsprozesses des Reflektors als auch während seines Einsatzes unter den oben genannten Bedingungen zu sichern und den geforderten hohen thermischen Emissionsgrad zu realisieren.

Vor diesem Hintergrund liegt der vorliegenden Erfindung die Aufgabe zugrunde, einen Reflektor mit möglichst hohem Reflexionsgrad herzustellen, welcher über einen langen Zeitraum bei hoher thermischer Belastung hinweg erhalten bleibt.

Dies gelingt mit einem Verfahren zur Herstellung eines thermisch belastbaren Reflektors gemäß den Merkmalen des Anspruchs 1. Weitere, sinnvolle Ausgestaltungsmerkmale eines derartigen Verfahrens können den Unteransprüchen entnommen werden.

Erfindungsgemäß ist vorgesehen, den geforderten hohen Reflexionsgrad durch die Verwendung von Silber in der Reflexionsschicht zu erreichen. Hierzu wird die Reflexionsschicht aus Silber zwischen einer substratseitigen Diffusionsbarriere und einer reflexionsseitigen Diffusionsbarriere eingeschlossen. Die substratseitige Diffusionsbarriere, welche auch als Haftvermittler dient, wird auf das Substrat aufgebracht und sorgt hierbei dafür, dass eine Diffusion zwischen Substrat und Reflexionsschicht funktionsentsprechend vermindert wird. Das Aufbringen der substratseitigen Diffusionsbarriere kann in herkömmlicher Weise geschehen, weil bei diesem ersten Bearbeitungsschritt das Silber noch nicht aufgetragen ist. Insoweit beeinträchtigt Sauerstoff, der zur Herstellung der substratseitigen Diffusionsbarriere allenfalls benötigt wird, das Ergebnis nicht.

Auf die substratseitige Diffusionsbarriere wird sodann die eigentliche Reflexionsschicht aus Silber aufgebracht und dann abweichend vom Stand der Technik nicht mit einer Aluminiumoxidschicht überzogen, sondern zunächst mit einer Aluminiumschicht. Durch diese Verkapselung der Silberschicht in der Aluminiumschicht kann nunmehr die Aluminiumschicht ihrerseits thermisch oder in einem Plasma einer Gasentladung einem oxidierenden Gas, vorzugsweise Sauerstoff, oxidiert werden, ohne dass hierbei die Reflexionsschicht aus Silber durch Korrosion oder Agglomeration nachteilig beeinflusst wird.

Die genannte Aluminiumschicht wird hierbei auf der Reflexionsschicht in einer Dicke von 2 bis 50 nm, idealerweise in einer Dicke zwischen 10 und 20 nm, aufgebracht. Die sich anschließende Oxidation des Aluminiums, bei welcher das Aluminiumoxid letztlich als transparenter Überzug über dem Silber entsteht, wird hierbei zweckmäßigerweise optisch auf Vollständigkeit überwacht werden.

Bei der Herstellung der substratseitigen Diffusionsbarriere, bei welcher weniger Rücksicht auf die Verwendung von Sauerstoff genommen werden muss, kann mit einigem Vorteil eine Plasma-Vorbehandlung des Substrats vor dem Auftragen der substratseitigen Diffusionsbarriere erfolgen. Die substratseitige Diffusionsbarriere ihrerseits kann ebenfalls aus Aluminiumoxid bestehen, allerdings ist es auch möglich, ein Oxid eines Übergangsmetalls zu verwenden. Soweit es sich bei dem verwendeten Oxid um das Oxid des Metalls handelt, aus welchem das Substrat hergestellt ist, kann die fragliche substratseitige Diffusionsbarriere durch Oxidation des Substrats selbst an dessen Oberfläche erfolgen.

Noch vor dem Auftragen der substratseitigen Diffusionsbarriere kann mit einigem Vorteil das Substrat vorgeglättet werden, so dass eine möglichst ebene Reflexionsschicht für eine besonders gute Reflexion sorgen kann. Hierzu ist es beispielsweise möglich, das Substrat zu polieren oder eine glättende Sol-Gel-Schicht aufzubringen, bevor die substratseitige Diffusionsbarriere aufgebracht wird.

Die Reflexionsschicht aus Silber wird auf die substratseitige Diffusionsbarriere mit einigem Vorteil durch physikalische Gasphasenabscheidung als optisch dichte Silberschicht aufgetragen. Hierbei sollte, um eine tatsächlich optisch dichte Silberschicht zu gewährleisten, eine Dicke oberhalb von 100 nm angestrebt werden.

Zur weiteren Erhöhung der Barrierewirkung können auf die reflexionsseitige Diffusionsbarriere eine oder mehrere weitere Schichten anderer transparenter Oxide mit Dicken bis zu 50 nm aufgebracht werden. Bei der Wahl der Werkstoffe muss beachtet werden, dass der spektrale Transmissionsbereich den spektralen Reflexionsbereich des Silbers vollständig überdeckt. Hierfür kommen Metalloxide und Metallfluoride in Betracht, die durch physikalische Gasphasenabscheidung aufgebracht werden. Die Reflexion kann durch konstruktive Interferenz an weiteren oxidischen Doppeloder Mehrfachschichten mit alternierend niedrigem und hohem Brechungsindex sowie hieran entsprechend angepasster Schichtdicke erhöht werden. Die Barrierewirkung dieser Schichten wird zusätzlich genutzt.

Die thermische Emissivität der Anordnung wird erfindungsgemäß durch eine hoch transparente, vorzugsweise silikatische Sol-Gel-Schicht gesichert, welche vorzugsweise durch Tauchen oder Spritzen aufgebracht und bei 120°C bis 200°C vernetzt wird. In bekannter Art und Weise kann schließlich eine Antireflexionsschicht entweder oberhalb oder unterhalb der Sol-Gel-Schicht aufgebracht und der Schichtstapel somit komplettiert werden.

Ein bevorzugtes Verfahren zur Herstellung eines derartigen Reflektors verwendet eine Bandbeschichtungsanlage, durch welche ein Substratband, welches wie oben beschrieben vorzugsweise zuvor geglättet wurde, hindurchgeführt wird. Es handelt sich hierbei um einen vakuumtechnischen Beschichtungsprozess ohne Vakuumunterbrechung. In separierten Kammern innerhalb der Bandbeschichtungsanlage wird die eigentliche Beschichtung vorzugsweise mithilfe von Rechteckmagnetron-Sputterquellen für die substratseitige Diffusionsbarriere, die Reflexionsschicht aus Silber und die auf das Silber zunächst zu applizierende Aluminiumschicht vorgenommen. In einer weiteren Kammer erfolgt die optisch kontrollierte thermische und/oder Plasmaoxidation der Aluminiumschicht. In weiteren Kammern werden erforderlichenfalls weitere Diffusionsbarrieren aufgebracht, gegebenenfalls gefolgt von einem Interferenzschichtsystem und der Antireflexionsschicht, ebenfalls durch reaktives Magnetron-Sputtern. Die Sol-Gel-Schicht mit einer Dicke von 1 bis 5 µm wird nach Ausschleusen in bekannter Weise, zum Beispiel durch Sprühen und thermisches Vernetzen in einem Durchlaufofen bei 120°C bis 200°C, vorzugsweise bei 130°C bis 180°C, aufgebracht.

Den einzelnen Kammern sind zur Aufrechterhaltung und Anpassung des Vakuums der jeweiligen Kammer benötigte Vakuumerzeuger zugeordnet. Insbesondere erfolgt nach dem Aufbringen der substratseitigen Diffusionsbarriere und nach dem Aufbringen der Aluminiumschicht auf die Reflexionsschicht und nach dem Aufbringen der Antireflexionsschicht eine Gasseparierung mittels eines Zwischenvakuums.

Die vorstehend beschriebene Erfindung wird im Folgenden anhand eines Ausführungsbeispiels näher erläutert.

Es zeigen
- Fig. 1: eine schematische Darstellung eines Schichtstapels in seitlicher Schnittdarstellung, welcher aufbauend auf einem geglätteten Substrat die verschiedenen zu applizierenden Schichten eines Reflektors wiedergibt, sowie
- Fig. 2: eine schematische Darstellung einer Bandbeschichtungsanlage zur Herstellung eines thermisch belastbaren Reflektors in einer seitlichen Querschnittsansicht.

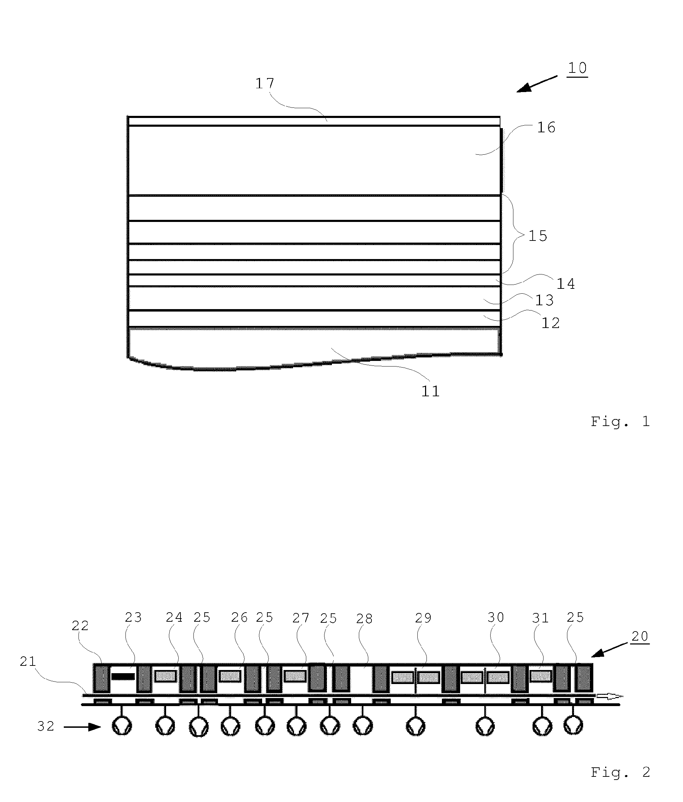

Figur 1 zeigt einen Reflektor 10 im Querschnitt, welcher als Stapel verschiedener Schichten aufgebaut ist. Auf einer geglätteten Substratschicht 11 ist zunächst eine substratseitige Diffusionsbarriere 12 aufgebracht, welche entweder durch Aufsputtern einer Aluminiumoxidschicht oder aber durch Oxidieren der Oberfläche des Substrats 11 entstanden ist. Auf diese substratseitige Diffusionsbarriere 12 folgt dann eine Reflexionsschicht 13 aus Silber, welche ihrerseits durch eine reflexionsseitige Diffusionsbarriere 14 abgeschlossen wird.

Bei der Herstellung der reflexionsseitigen Diffusionsbarriere 14, welche ebenfalls aus Aluminiumoxid besteht, ist zu beachten, dass durch die für ein herkömmliches Auftragen der Aluminiumoxidschicht erforderliche Anwesenheit von Sauerstoff eine Beschädigung der Silberschicht zu besorgen ist, so dass erfindungsgemäß nicht direkt eine Aluminiumoxidschicht auf die Reflexionsschicht 13 aufgetragen wird, sondern diese zunächst mit einer Aluminiumschicht überzogen wird, welche dann thermisch oder in einem Plasma einer Gasentladung mit Sauerstoff oxidiert wird. Dieses Vorgehen gewährleistet, dass der für die Oxidation erforderliche Sauerstoff mit der Reflexionsschicht 13 aus Silber nicht in Kontakt kommt und diese nicht korrodieren kann und keine Agglomerationen verursacht. Hierdurch bleibt der hohe Reflexionsgrad des Silbers erhalten, während durch die schließlich durch vollständige Oxidation der Aluminiumschicht entstandene Aluminiumoxidschicht eine Sauerstoffbarriere realisiert wird.

Auf diese reflexionsseitige Diffusionsbarriere 14 folgen weitere Barriereschichten 15, wobei es sich hierbei um andere transparente Oxide mit Dicken bis zu 50 nm handelt. Aufgrund der gewählten Brechungsindizes und der angepassten Schichtdicken verhelfen diese Schichten zu einer konstruktiven Interferenz und damit einer weiteren Verbesserung des Reflexionsgrades der Gesamtanordnung.

Eine Sol-Gel-Schicht 16 sowie eine Antireflexionsschicht 17 schließen den Schichtstapel.

Figur 2 zeigt schematisch eine Bandbeschichtungsanlage 20, mit welcher das erfindungsgemäße Herstellungsverfahren betrieben werden kann. Hierzu wird ein vorab geglättetes, insbesondere poliertes Substratband 21 in die Bandbeschichtungsanlage 20 eingeführt und durch diese hindurch bewegt. Die Bandbeschichtungsanlage 20 besteht im Wesentlichen aus einer Reihe von Kammern, welche eingangs mit einer Druckstufe 22 abgeschlossen und untereinander durch Druckstufen und Zwischenvakuumkammern verbunden sind und jeweils über eigene Vakuumerzeuger 32 den erforderlichen Arbeitsdruck aufweisen. In Richtung des in Figur 2 gezeigten Pfeils durchläuft das Substratband 21 der Reihe nach zunächst eine Schleusenkammer 23, in der das zu beschichtende Bandmaterial vorbehandelt werden kann, beispielsweise in Plasma eine Glimmentladung. Es schließt sich eine erste Beschichtungskammer 24 zum Auftragen der substratseitigen Diffusionsbarriere aus Aluminiumoxid an. Es handelt sich hierbei um eine reaktive Aluminiumoxidabscheidung mit Sauerstoff, mithilfe einer Magnetron-Sputterquelle. Es folgt ein Zwischenvakuum 25, welches dafür sorgt, dass im nachfolgenden Bearbeitungsschritt in der Beschichtungskammer 26, in welcher eine Silberabscheidung auf die Aluminiumoxidschicht erfolgt, kein Sauerstoff in diese Beschichtungskammer 26 eintritt, welcher bei der Silberabscheidung zu Korrosion bzw. Agglomeration führen könnte.

Es folgt ein Zwischenvakuum 25 und eine Beschichtungskammer 27 zum Aufbringen einer Aluminiumschicht auf die silberne Reflexionsschicht. Nach einem erneuten Zwischenvakuum 25 tritt das Substratband 21 dann in eine Oxidationskammer 28 ein, in welcher das Aluminium mit Sauerstoff zu Aluminiumoxid oxidiert wird. Aufgrund der Trennung dieser beiden Schritte und des Zwischenvakuums 25 wird das in der Beschichtungskammer 26 aufgebrachte Silber mit dem letztlich in der Oxidationskammer 28 vorhandenen Sauerstoff nicht direkt in Kontakt kommen, so dass dieser die Silberschicht nicht negativ beeinflussen kann. Hierdurch wird der hohe Reflexionsgrad des Silbers beibehalten und ein ideales Ergebnis für die Herstellung des Reflektors erzielt.

In einer weiteren Beschichtungskammer 29 erfolgt eine reaktive Siliziumoxid- und weitere Oxidbeschichtungen mithilfe von Magnetron-Sputterquellen, in der Beschichtungskammer 30 eine reaktive Oxidbeschichtung mit λ/4-Schichten, ebenfalls unter Verwendung von Magnetron-Sputterquellen. In einer letzten Beschichtungskammer 31 erfolgt schließlich eine reaktive Beschichtung mit einer Antireflexionsschicht, wofür ebenfalls ein Magnetron verwendet wird. Nach erneuter Gasseparierung im Zwischenvakuum 25 und einer Druckstufe tritt das Substratband 21 aus der Bandbeschichtungsanlage 20 aus und wird in einem letzten Schritt außerhalb der Bandbeschichtungsanlage 20 durch Tauchen oder Spritzen mit einer Sol-Gel-Schicht versehen, welche dann unter Wärmeeinwirkung vernetzt wird.

Vorstehend beschrieben ist somit ein Verfahren zur Herstellung eines thermisch belastbaren, hoch reflektiven Reflektors mit einer Reflexionsschicht aus Silber, bei dem eine Einwirkung von Sauerstoff beim Aufbringen von Diffusionsbarrieren um die Reflexionsschicht aus Silber herum verhindert wird. Beim Aufbringen der reflexionsseitigen Diffusionsschicht wird hierbei ein zweistufiges Verfahren verwendet, bei dem zunächst eine Aluminiumschicht aufgetragen und diese dann in einem zweiten Schritt oxidiert wird.

### BEZUGSZEICHENLISTE

- 10: Reflektor
- 11: Substrat
- 12: substratseitige Diffusionsbarriere
- 13: Reflexionsschicht
- 14: reflexionsseitige Diffusionsbarriere
- 15: weitere Barriereschichten
- 16: Sol-Gel-Schicht
- 17: Antireflexionsschicht
- 20: Bandbeschichtungsanlage
- 21: Substratband
- 22: Druckstufe
- 23: Schleusenkammer
- 24: Beschichtungskammer
- 25: Zwischenvakuum
- 26: Beschichtungskammer
- 27: Beschichtungskammer
- 28: Oxidationskammer
- 29: Beschichtungskammer
- 30: Beschichtungskammer
- 31: Beschichtungskammer
- 32: Vakuumerzeuger

## Patentansprüche

1. Verfahren zur Herstellung eines thermisch belastbaren Reflektors (10), insbesondere für solarthermische Anwendungen, wobei eine Reflexionsschicht (13) aus Silber unter Zwischenlage einer haftvermittelnden substratseitigen Diffusionsbarriere (12) auf ein Substrat (11) aufgebracht wird und die Reflexionsschicht (13) ihrerseits mit einer reflexionsseitigen Diffusionsbarriere (13) aus Aluminiumoxid überzogen wird,
**dadurch gekennzeichnet, dass** zur Herstellung der reflexionsseitigen Diffusionsbarriere (14) zunächst eine Aluminiumschicht auf die Reflexionsschicht (13) aufgebracht wird und die Aluminiumschicht sodann thermisch oder in einem Plasma einer Gasentladung, vorzugsweise mit Sauerstoff, oxidiert wird.

2. Verfahren gemäß Anspruch 1, **dadurch gekennzeichnet, dass** die Aluminiumschicht auf der Reflexionsschicht (13) in einer Dicke von 2 bis 50 nm, vorzugsweise in einer Dicke von 10 bis 20 nm, aufgebracht wird.

3. Verfahren gemäß einem der Ansprüche 1 oder 2, **dadurch gekennzeichnet, dass** die Vollständigkeit der Oxidation des Aluminiums optisch überwacht wird.

4. Verfahren gemäß einem der vorhergehenden Ansprüche, **dadurch gekennzeichnet, dass** vor dem Auftragen der substratseitigen Diffusionsbarriere (12) und/oder der reflexionsseitigen Diffusionsbarriere (14) eine Plasma-vorbehandlung erfolgt.

5. Verfahren gemäß einem der vorhergehenden Ansprüche, **dadurch gekennzeichnet, dass** es sich bei der substratseitigen Diffusionsbarriere (12) um eine Aluminiumoxidschicht oder eine Schicht aus einem Oxid eines Übergangsmetalls handelt.

6. Verfahren gemäß einem der vorhergehenden Ansprüche, **dadurch gekennzeichnet, dass** die Reflexionsschicht (13) durch physikalische Gasphasenabscheidung als optisch dichte Silberschicht, vorzugsweise in einer Dicke von wenigstens 100 nm, auf die substratseitige Diffusionsbarriere (12) aufgebracht wird.

7. Verfahren gemäß einem der vorhergehenden Ansprüche, **dadurch gekennzeichnet, dass** das Substrat (11) vor dem Auftragen der substratseitigen Diffusionsbarriere (12) geglättet, vorzugsweise auf eine RMS-Rauheit unter 10 nm poliert, wird.

8. Verfahren gemäß einem der vorhergehenden Ansprüche, **dadurch gekennzeichnet, dass** auf die reflexionsseitige Diffusionsbarriere (14) weitere Barriereschichten (15) aus transparenten Metalloxiden, vorzugsweise mit Dicken bis zu 50 nm, aufgetragen werden.

9. Verfahren gemäß Anspruch 8, **dadurch gekennzeichnet, dass** das Aufbringen der weiteren Barriereschichten (15) durch physikalische Gasphasenabscheidung erfolgt.

10. Verfahren gemäß einem der Ansprüche 8 oder 9, **dadurch gekennzeichnet, dass** die weiteren Barriereschichten (15) jeweils derart aufgebracht werden, dass sich Materialien mit höherem und niedrigerem Brechungsindex abwechseln.

11. Verfahren gemäß einem der vorhergehenden Ansprüche, **dadurch gekennzeichnet, dass** eine Sol-Gel-Schicht (16) zur Sicherung der thermischen Emissivität, vorzugsweise durch Tauchen oder Spritzen und vorzugsweise mit einer Dicke von 1 bis 5 µm, aufgebracht und bei 120°C bis 200°C vernetzt wird.

12. Verfahren gemäß Anspruch 11, **dadurch gekennzeichnet, dass** eine Antireflexionsschicht (17) unterhalb oder oberhalb der Sol-Gel-Schicht (16) aufgetragen wird.

13. Verfahren gemäß einem der vorhergehenden Ansprüche, **dadurch gekennzeichnet, dass** die Herstellung des Reflektors (10) mittels einer Bandbeschichtungsanlage (20) erfolgt, durch welche ein, vorzugsweise zuvor geglättetes, Substratband (21) hindurchgeführt wird.

14. Verfahren gemäß Anspruch 13, **dadurch gekennzeichnet, dass** das Aufbringen von Metallen bzw. Oxiden in entlang der Bandbeschichtungsanlage (20) angeordneten Beschichtungskammern (24, 26, 27, 29, 30, 31) durchgeführt wird, wobei vorzugsweise eine Magnetron-Sputterquelle zum Aufsputtern der Metalle bzw. Oxide eingesetzt wird.

15. Verfahren gemäß einem der Ansprüche 13 oder 14, **dadurch gekennzeichnet, dass** eingangs der Bandbeschichtungsanlage (20) über eine Druckstufe (22) in einer Schleusenkammer (23) ein für die folgende Beschichtungskammer ausreichender Unterdruck erzeugt wird, wo auch eine Vorbehandlung zur Reinigung des Bandmaterials erfolgen kann, wobei die Kammern der Bandbeschichtungsanlage (20) mit jeweils angepassten Vakuumerzeugern (32) ausgerüstet sind.

16. Verfahren gemäß Anspruch 15, **dadurch gekennzeichnet, dass** ein Zwischenvakuum (25) zur Gasseparierung zwischen benachbarten Beschichtungskammern (24, 26, 27, 29, 30, 31) angeordnet sind.
